# EUROPEAN PATENT APPLICATION

(11) **EP 0 851 495 A1**
(43) Date of publication of application: **01.07.1998**
(21) Application number: 96830647.2
(22) Date of filing: 24.12.1996
(51) Int. Cl.: H01L 27/105, H01L 29/08

(54) **N-Channel MOS transistor with NO LDD junction and corresponding manufacturing method**

(71) Applicant: SGS-THOMSON MICROELECTRONICS s.r.l., 20041 Agrate Brianza (Milano) (IT)
(72) Inventor: Fontana, Gabriella, c/o SGS-Thomson, 20041 Agrate Brianza (Milano) (IT); Annunziata, Roberto, c/o SGS-Thomson, 20041 Agrate Brianza (Milano) (IT)
(74) Representative: Botti, Mario

(57) **Abstract**

The invention relates to an N-channel MOS transistor structure having a NO LDD junction, and to a manufacturing process therefor.

The transistor is of the type which is incorporated into CMOS structures of electronic memory devices (2) integrated on a semiconductor substrate (3) and comprising a plurality of memory cells (2), each cell being comprised of a floating gate transistor (11) with active areas (5) formed on the substrate (3) laterally of the gate region (11). The transistor has source (15) and/or drain (11) regions formed on the substrate (3) at adjacent locations to the locations of the active areas (5) of the memory cell (2).

## Description

### Field of the Invention

This invention relates to an N-channel MOS transistor having a NO LDD junction, and to a manufacturing process therefor.

Specifically, the invention relates to an N-channel MOS transistor with a NO LDD junction, of the type incorporated into CMOS structures of electronic memory devices which are integrated on a semiconductor substrate and comprise a plurality of memory cells, each having a floating gate with active areas formed on the substrate laterally of the gate region.

The invention also relates to a process for making an N-channel MOS transistor having a NO LDD junction and being of the type which is incorporated into CMOS structures of electronic memory devices integrated on a semiconductor substrate.

### Background Art

As is well known, the process of manufacturing electronic memory devices integrated on a semiconductor involves of necessity the formation of N-channel MOS transistors having junctions of the NO LDD type.

Such transistors are mainly used as pull-down elements in output buffer CMOS stages incorporated into the memory devices.

In particular, the memory devices wherein such transistors are mostly utilized may be non-volatile memories of the virtual ground EEPROM or FLASH EPROM type. These memories include continuous parallel diffusion strips, termed the bit lines, which interconnect the active areas of the memory cells. Memories of this type are also referred to as contact-less memories, since they only require termination contacts for the bit lines. In addition, they require virtual ground circuitry for the reading and programming operations.

European Patent No. 0 573 728 discloses the construction of virtual ground non-volatile memories as well as a method of forming transistors with LDD indexed junctions.

CMOS processes usually yield N-channel transistors which have a dual junction profile, that is an LDD indexed junction, conferring a degree of immunity to hot carriers and improved reliability on the CMOS structure.

Accordingly, in the course of a standard CMOS process, it is not automatically possible to form transistors with non-indexed LDD junctions for the output stages. This would in fact be inconsistent with a conventional process flow and require additional processing steps and masks.

On the other hand, N-channel MOS transistors of the NO LDD type are less likely to be damaged by EOS-ESD, and would enable self-protected output buffer stages to be provided.

In all cases, they would provide improved performance for already self-protected CMOS stages.

It is the object of this invention to provide a low-voltage (LV) or high-voltage (HV) MOS transistor of the NO LDD type suitable for use with CMOS structures to be incorporated into integrated EPROM or FLASH EPROM memory circuits.

For a better appreciation of the aspects of this invention, it should be considered that certain planarization processes impose limitations on the largest admissible size of the junctions, which must be held within the miniminum allowed by photolithography.

Many semiconductor integrated memory circuit structures require that the polysilicon strips which bound the bit lines be kept at fixed spacings; it is only by so doing that the level of planarization of the dielectrics deposited in the interspaces between such strips can be optimized.

This prevents, however, the junctions from being formed with a sufficient width to allow the termination contacts of the bit lines to be located in regions facing the gate regions of the MOS transistors. But such lessened junctions are inconsistent with the dimensions required of an N-channel transistor to be incorporated into a CMOS stage.

The underlying technical problem of this invention is to provide a novel N-channel MOS transistor structure having NO LDD junctions, which has such constructional and functional features as to allow of its integration with CMOS stages incorporated into virtual ground integrated memory circuits, thereby overcoming the limitations and/or shortcomings of prior art approaches.

### Summary of the Invention

The solution idea on which this invention stands is to provide a NO LDD junction in an active area region adjacent to the gate region, and have this junction linked to an N+ diffusion of a conventional N-channel MOS transistor.

Based on this solution idea, the technical problem is solved by a MOS transistor as indicated above and defined in the characterizing portion of Claim 1.

The problem is also solved by a process for forming MOS transistors in semiconductor integrated electronic memory devices as defined in the characterizing portion of Claim 7.

The features and advantages of the transistor and process according to the invention will be apparent from the following description of an embodiment thereof, given by way of non-limitative example with reference to the accompanying drawings.

### Brief Description of the Drawings

In the drawings:
Figure 1 is an enlarged scale plan view showing schematically a portion of a semiconductor integrated circuit wherein a transistor according to the invention is formed;
Figure 2 is an enlarged scale vertical cross-section view showing a detail of the circuit in Figure 1, taken along a line A-A;
Figure 3 is an enlarged scale plan view showing schematically the integrated circuit portion of Figure 1 at a subsequent stage of the manufacturing process;
Figure 4 is an enlarged scale vertical cross-section view showing a detail of the circuit in Figure 3, taken along a line B-B;
Figures 5 and 6 respectively show, in voltage vs. current plots, comparative characteristic curves for indexed junction MOS transistors and the MOS transistor of this invention;
Figure 7 is another voltage vs. current plot showing comparative breakdown characteristic curves for indexed junction MOS transistors and the MOS transistor of this invention;
Figure 8 is a comparative accumulated distribution plot of ESD HBM breakdown voltages in CMOS input and/or output stages incorporating conventional MOS transistors and MOS transistors according to the invention.

### Detailed Description

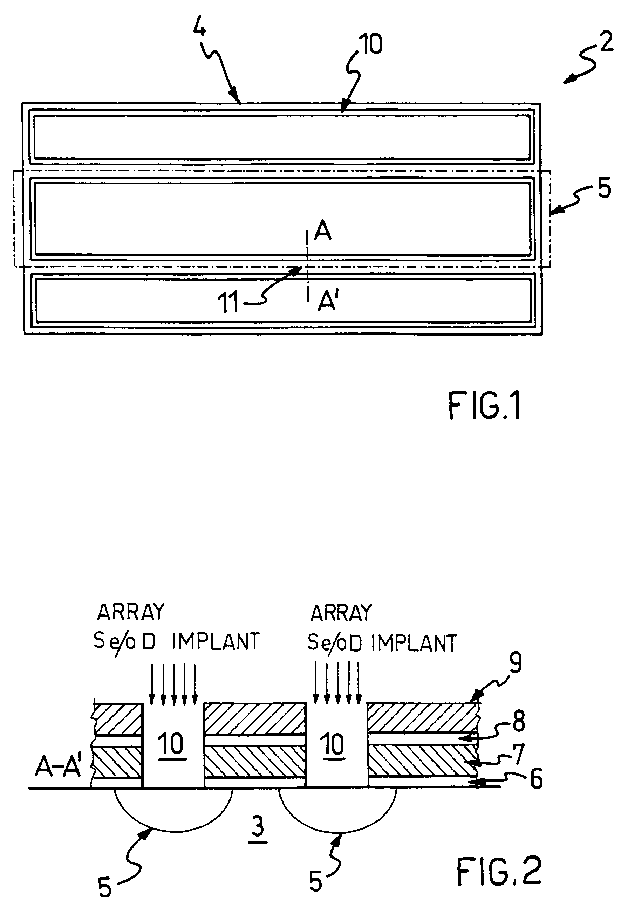

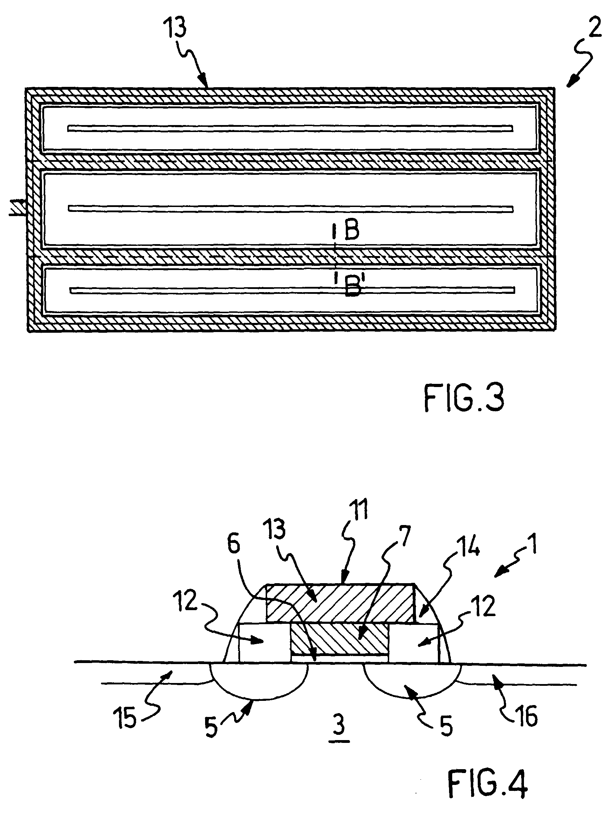

Referring to the drawing figures, specifically to figures 1 and 4, a portion of an electronic memory device 2, in the form of a semiconductor integrated circuit, is generally and schematically shown therein.

The device may be a virtual ground EPROM or FLASH EPROM memory, e.g. as that described in European Patent No. 573 728 to this Applicant.

The device comprises a plurality of floating gate transistors which form memory cells organized into a matrix structure having a plurality of rows, referred to as the word lines, and a plurality of columns, referred to as the bit lines.

The memory matrix is formed on a semiconductor substrate 3 and includes continuous parallel diffusion strips 4 interconnecting active areas 5 of the transistors which make up the memory cells. The strips 4 are the matrix bit lines, and memories of this type are called contact-less memories or cross-point memories, requiring virtual ground circuitry for the read and program operations.

A multi-layer structure is formed over the substrate 2 which comprises;
a thin oxide layer 6, also referred to as the gate oxide;
a first polysilicon layer, or poly1, layer for forming the floating gates of the memory cells;
an interpoly dielectric layer 8, usually of ONO (Oxide-Nitride-Oxide);
a covering layer 9, also referred to as the poly cap or dummy poly.

Presently the manufacturing process is continued by digging trench-like openings 10 in the active areas 5. These openings are produced by means of a cascade step of etching away the cap layer 9, dielectric layer 8, poly1 layer 7, and tunnel oxide 6 to expose the substrate 3.

A gate region 11 of the NO LDD transistor is defined between each pair of openings 10.

Advantageously, the gate region 11 is defined during this cascade etching step using the same photolithographic mask as enables the bit lines to be defined in the matrix.

The active areas 5, once exposed by the cascade etching whereby the trench-like openings 10 are defined, are subjected to an implantation step followed by diffusion to form the source and drain regions of the NO LDD transistor.

The implantation is effected with arsenic and phosphorus ions.

In particular, it can be appreciated from the example of Figure 2 that the diffusions of the active areas 5 are asymmetrical in that, while one region is implanted with arsenic only, the other region is implanted with arsenic and phosphorus, as is done in the FLASH EPROM cell forming process, for example.

This preferential choice results in two active areas being formed with different sizes; in fact, one of the two areas is definitely larger than the other.

Alternatively, the active areas 5 could obviously be made symmetrical, as in the instance of the EPROM cells.

At the end of the implantation step, the trench-like openings 10 are filled with a planarizing dielectric material 12, only shown in Figure 4.

At this point, the process provides for removal of the cap layer 9 and the dielectric layer 8.

This step of etching away the upper layers will not remove the planarizing dielectric 12 thoroughly from above the junction. This expedient allows other transistors to be formed consistently for incorporation to the virtual ground circuitry associated with the memory matrix.

After removing the layers 9 and 8, a second layer 13 of polysilicon, or poly2, is deposited.

A further layer of silicide may be applied, if desired, to cover the poly2 layer 13.

The deposition of the poly2 layer 13 is allowed by the same photolithographic mask as has been used to define the gate regions 11 of the transistors.

The photolithographic process is to ensure that a film of resist, not shown because known per se, will always mask off the portions of the tunnel oxide layer 6 and the poly1 layer 7 which belong to the gate region 11 and are bounded by the planarizing dielectric 12.

At this point, an implant of phosphorus dopant is effected by conventional steps of the manufacturing process to form the N- and LDD junctions of peripheral transistors in the memory matrix.

Yet another conventional process step consists of depositing and anisotropically etching so-called oxide spacers 14 to confer laterally protection on the gate regions 11 of the memory cells 2.

In addition, an implant followed by diffusion is effected, preferably using arsenic N+ ions, to form source regions 15 and/or drain regions 16 of the N-channel transistors in accordance with the invention.

These sources 15 and/or drains 16 are formed on the substrate 3 at adjacent locations to the location of the active areas 5, to establish an electrical contact therewith. In this way, the diffused area of the source and drain junctions of the N-channel transistors according to the invention is linked to the source or drain active areas 5, thereby providing non-indexed profile, or NO LDD, junctions.

Specifically, each of said source 15 and/or drain 16 regions is in contact with, and partially overlap, the corresponding active area 5 formed similar to that of a FLASH or EPROM memory cell.

In any case, each of said source 15 and/or drain 16 regions will make electrical contact with its adjacent active area 5. Also, as shown in Figure 4, the gate region 11 is protected laterally by the oxide spacers 14, and said source 15 and/or drain 16 regions will contact the corresponding active area 5 of the transistor at the spacers 14.

For example, where the N-channel transistors are in a FLASH memory matrix, they would be formed with the source junctions of the FLASH cells.

On the contrary, where the N-channel transistors are incorporated into a matrix of the EPROM type. the drain regions, doped N+, of the N-channel transistor would contact the corresponding drain regions of the EPROM cells.

Arsenic alone is used to form the junctions of the EPROM type cells, whereas arsenic and phosphorus are used for the FLASH memory cells.

It will be appreciated, from the foregoing description, that the transistor of this invention has non-indexed NO LDD junctions, and can be readily utilized as a pull-down transistor in output buffer CMOS stages of memory matrices.

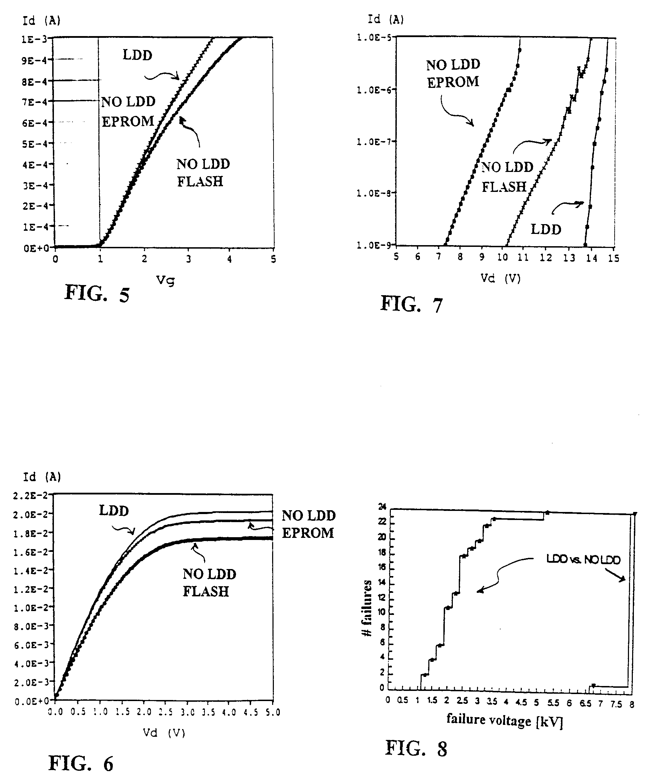

Figures 5 and 6 show, in respective voltage vs, current plots, comparative characteristic curves for indexed junction MOS transistors and the MOS transistor of this invention. As can be appreciated from such comparative curves, the characteristics of the inventive transistor are superior, both when associated with FLASH memory cells and with EPROM memory cells.

Figure 7 is another plot of voltage vs. current showing comparative breakdown characteristic curves of indexed junction MOS transistors and the MOS transistor of this invention.

Figure 8 is an accumulated distribution plot of ESD HBM breakdown voltages in input and/or output CMOS stages incorporating conventional MOS transistors as compared with MOS transistors according to the invention.

Changes and modifications may be made unto the inventive transistor, still within the scope of the invention as defined in the following claims.

## Claims

1. An N-channel MOS transistor having a NO LDD junction and of the type incorporated into CMOS structures of electronic memory devices (2) which are integrated on a semiconductor substrate (3) and comprise a plurality of EPROM or FLASH memory cells (2) having active areas (5) formed on the substrate (3) laterally of a gate region (11), characterized in that said transistor has source (15) and/or drain (16) regions formed on the substrate (3) at adjacent locations to the locations of said active areas (5).

2. An N-channel transistor according to Claim 1, characterized in that each of said source (15) and/or drain (16) regions is in contact with, and partly overlaps, its corresponding active area (5).

3. An N-channel transistor according to Claim 1, characterized in that each of said source (15) and/or drain (16) regions makes electrical contact with the corresponding active areas (5) and defines a non-indexed junction profile.

4. An N-channel transistor according to Claim 1, characterized in that said gate region (11) is protected laterally by oxide spacers (14), and that said source (15) and/or drain (16) regions contact their corresponding active areas (5) at the spacers (14).

5. An N-channel transistor according to Claim 1, characterized in that said source (15) and/or drain (16) regions are doped N+.

6. An N-channel transistor according to Claim 1, characterized in that said source (15) and/or drain (16) regions are formed by implantation followed by diffusion.

7. A process for fabricating an N-channel MOS transistor with a NO LDD junction and incorporated into CMOS structures of electronic EPROM or FLASH memory devices (2) which are integrated on a semiconductor substrate (3), said devices comprising a plurality of memory cells which have active areas (5) formed on the substrate (3) laterally of a gate region (11), characterized in that it provides for the formation of source (15) and/or drain (16) regions of said MOS transistor on the substrate (3) at an adjacent location to the locations of said active areas (5), along with the definition of a non-indexed junction profile.

8. A process according to Claim 7, characterized in that each of said source (15) and/or drain (16) regions is in contact with, and partly overlaps, its corresponding active area (5).

9. A process according to Claim 7, characterized in that said gate region (11) is protected laterally by oxide spacers (14), and that said source (15) and/or drain (16) regions contact their corresponding active areas (5) at the spacers (14).

10. A process according to Claim 7, characterized in that said source (15) and/or drain (16) regions are doped N+ and formed by implantation followed by diffusion.
